# EUROPÄISCHE PATENTANMELDUNG

(11) **EP 1 972 950 A1**
(43) Veröffentlichungstag der Anmeldung: **24.09.2008**
(21) Anmeldenummer: 08001547.2
(22) Anmeldetag: 28.01.2008
(51) Int. Cl.: G01R 23/20

(54) **Verfahren und Messvorrichtung zum Messen von Störaussendungen mit aktiver Trägerunterdrückung**

(30) Priorität: 22.03.2007 DE 102007013757
(71) Anmelder: Rohde & Schwarz GmbH & Co. KG, 81671 München (DE)
(72) Erfinder: Schwarz, Klaus-Dieter, 85630 Neukeferloh (DE); Hählke, Benjamin, 57629 Höchstenbach (DE); Kiermaier, Josef, 82362 Weilheim (DE)
(74) Vertreter: Körfer, Thomas

(57) **Zusammenfassung**

Ein Verfahren zum Messen von Störaussendungen eines aktiv sendenden Messobjekts (100) zeichnet sich durch folgende Verfahrensschritte aus: das aktiv sendende Messobjekt (100) wird in einen Zustand versetzt, in welchem es ein bekanntes Datenmuster als Hochfrequenz-Signal aussendet. Aus einem identischen Datenmuster wird ein ideales Hochfrequenz-Signal erzeugt. Die beiden Hochfrequenz-Signale werden überlagert, wobei die Phasen um 180° verschoben sind. Das resultierende Signal enthält nur noch die Störaussendungen des Messobjekts (100), welche von einem Signalanalysator (130) analysiert werden.

## Beschreibung

Die Erfindung betrifft ein Verfahren und eine Messvorrichtung zum Messen von Störaussendungen eines aktiv sendenden Messobjekts mit einem Kommunikationsverbindungsteilnehmer, einem Signalgenerator und einem Signalanalysator.

Bislang wurde zur Messung der Störaussendung zur Ermittlung der Standardkonformität von aktiv sendenden Messobjekten, wie beispielsweise Mobiltelefonen, das Trägersignal durch Bandsperrfilter aus dem gesendeten Hochfrequenz-Signal entfernt. Da jedes einzelne Messobjekt eine Vielzahl von Frequenz-Kanälen nutzen kann, ist zur vollständigen messtechnischen Erfassung nach dem herkömmlichen Verfahren ein abstimmbares Bandsperrfilter oder eine Vielzahl an festen Bandsperrfiltern notwendig. Beiden Lösung ist der hohe technische und damit finanzielle Aufwand und der große benötigte Einbauraum gemein.

Zum allgemeinen Stand der Technik sei hier z.B. auf die DE 102 19 340 A1 verwiesen. In dieser Druckschrift wird eine Messvorrichtung und ein Verfahren zur Messung von Intermodulationsverzerrungen eines Messobjekts beschrieben. Das Messobjekt ist dort jedoch nicht ein aktiv sendendes Messobjekt, sondern ein signalumformendes Messobjekt, wie z.B. ein Verstärker. D.h. das Signal wird nicht von dem Messobjekt erzeugt, sondern ein Eingangs-Signal wird zu einem Ausgangs-Signal umgeformt, z.B. verstärkt.

Der Erfindung liegt die Aufgabe zugrunde, ein Verfahren und eine Messvorrichtung zu schaffen, um die Trägerunterdrückung zur Messung der Störaussendungen aktiv sendender Messobjekte auf eine einfache, preisgünstige und platzsparende Weise durchzuführen und gleichzeitig eine ebenso starke und frequenzselektive Unterdrückung wie bei der Verwendung von Bandsperrfiltern zu erreichen.

Die Aufgabe wird durch die Merkmale des Anspruchs 1 bezüglich des Verfahrens und die Merkmale des Anspruchs 7 bezüglich der Vorrichtung gelöst. Die Unteransprüche betreffen vorteilhafte Weiterbildungen der Erfindung.

Der Erfindung liegt das Konzept zugrunde, die Störaussendungen eines aktiv sendenden Messobjekts bei aktiver Unterdrückung des Trägersignals zu messen. Hierzu wird das Messobjekt in einen Zustand versetzt, in welchem es eingehende Daten direkt als ein ausgehendes moduliertes Hochfrequenz-Signal aussendet. Das Messobjekt wird mit bekannten Daten beaufschlagt. Eine auf den Hochfrequenzträger aufmodulierte Repräsentation der bekannten Daten wird daraufhin von dem Messobjekt ausgesendet. In einem Signalgenerator wird ein aus der bekannten Datenfolge generiertes ideales Hochfrequenz-Signal erzeugt, welches dem von dem Messobjekt erzeugten Signal in einem Signalkombinierer überlagert wird.

Vorteilhafterweise wird die Phase des im Signalgenerator erzeugten Signals so eingestellt, dass sie am Signalkombinierer der invertierten Phase des im Messobjekt erzeugten Signals am Signalkombinierer entspricht. Durch destruktive Interferenz löschen sich die identischen Teile der Hochfrequenz-Signale aus. Es verbleibt ein Restsignal, welches nur aus den Störaussendungen des Messobjekts besteht.

Vorteilhafterweise wird das im Signalgenerator erzeugte Signal so generiert, dass die Frequenz möglichst genau der Frequenz des vom Messobjekt generierten Signals entspricht. Ebenso wird vorteilhafterweise die Phase des Signals derart eingestellt, dass eine Phasenverschiebung von 180° zwischen den Signalen möglichst genau eingehalten wird. Eine Einstellschrittweite von mindestens 0,2°, besser 0,1° ist dabei vorteilhaft.

Um maximale Auslöschung zu erreichen, müssen neben Frequenz und Phase ebenfalls die Amplituden der Signale übereinstimmen. Hierzu wird beispielsweise die Amplitude des von dem Messobjekt erzeugten Signals mittels eines Dämpfungsglieds auf ein messtechnisch handhabbares, dem Signalgenerator-Signals ähnliches Niveau gedämpft. Zusätzlich wird beispielsweise zur Feinabstimmung die Amplitude des im Signalgenerator erzeugten Hochfrequenz-Signals genau eingestellt, damit die am Signalkombinierer ankommenden Hochfrequenz-Signale eine möglichst ähnliche Amplitude haben.

Handelt es sich bei dem Messobjekt beispielsweise um ein mobiles Kommunikationsgerät, insbesondere ein zelluläres Mobilfunkgerät oder Mobiltelefon, so kann der bekannte Datenstrom über eine aktive Kommunikationsverbindung über die Luftschnittstelle übertragen werden.

Ausführungsbeispiele der Erfindung werden nachfolgend unter Bezugnahme auf die Zeichnung näher beschrieben. In der Zeichnung zeigen:
- Fig. 1: ein erstes Ausführungsbeispiel einer erfindungsgemäßen Vorrichtung zur Messung von Störaussendungen eines aktiv sendenden Messobjekts;
- Fig. 2: das erste Ausführungsbeispiel einer erfindungsgemässen Vorrichtung zur Messung von Störaussendungen eines aktiv sendenden Messobjekts mit Signalflussplan;
- Fig. 3: ein zweites Ausführungsbeispiel einer erfindungsgemässen Vorrichtung zur Messung von Störaussendungen eines aktiv sendenden Messobjekts;
- Fig. 4: eine beispielhafte Darstellung des Ausgangssignals des Messobjekts im Frequenzbereich;
- Fig. 5: eine beispielhafte Frequenz-Kennlinie eines dem Stand der Technik angehörenden Bandsperrfilters;
- Fig. 6: eine beispielhafte Darstellung der überlagerten Hochfrequenzsignale am Ausgang des Signalkombinierers;
- Fig. 7: eine beispielhafte Darstellung der aktiven Auslöschung durch destruktive Interferenz in Abhängigkeit des Phasenwinkels;
- Fig. 8: eine beispielhafte Darstellung eines Hochfrequenz-Signals im Zeitbereich und
- Fig. 9: eine beispielhafte Darstellung eines Hochfrequenz-Signals im Zeitbereich nach aktiver Trägerunterdrückung

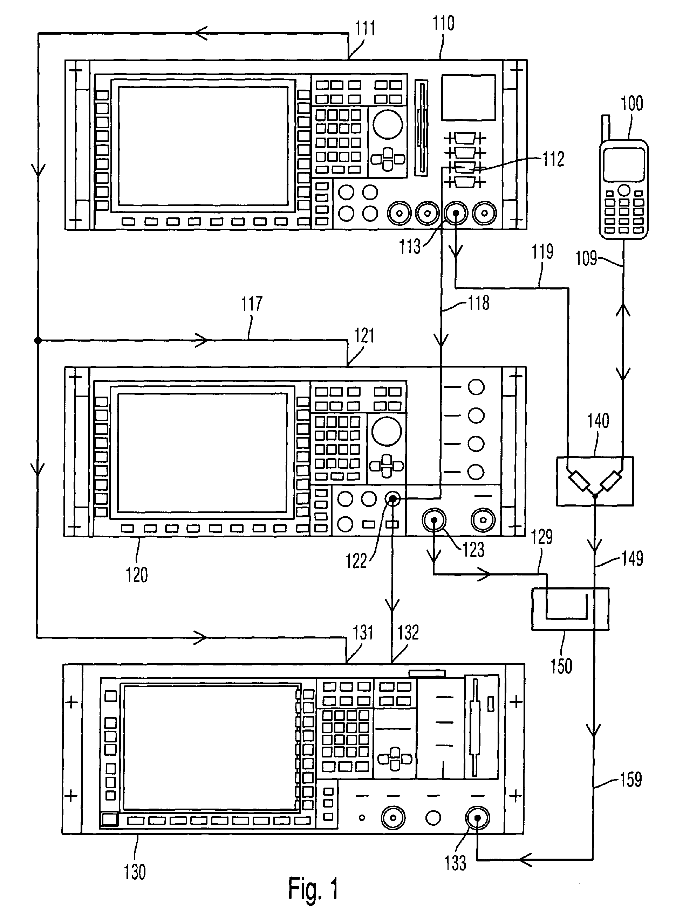

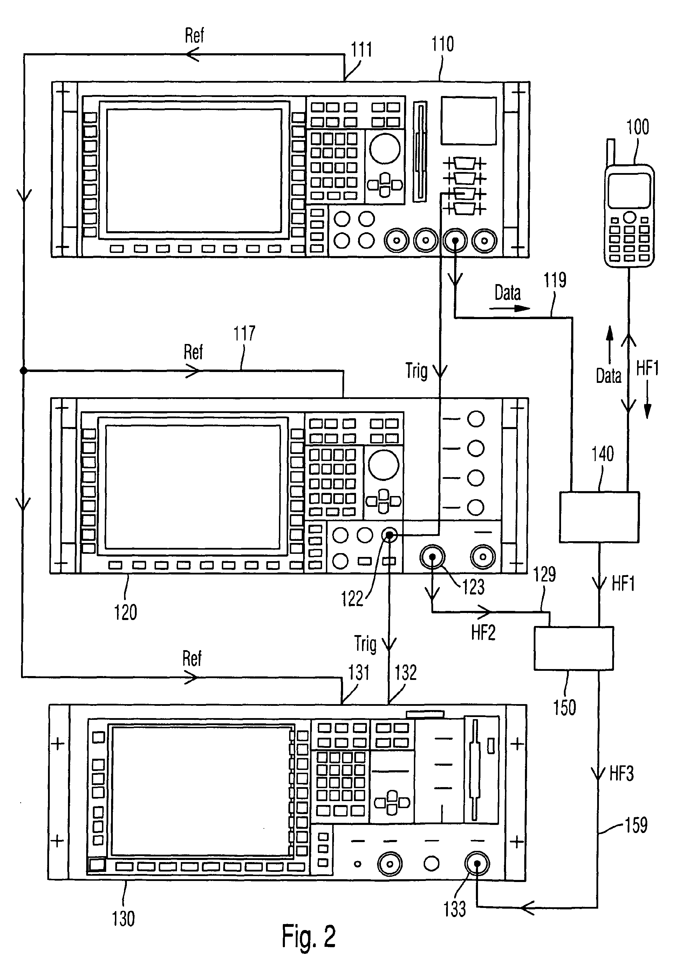

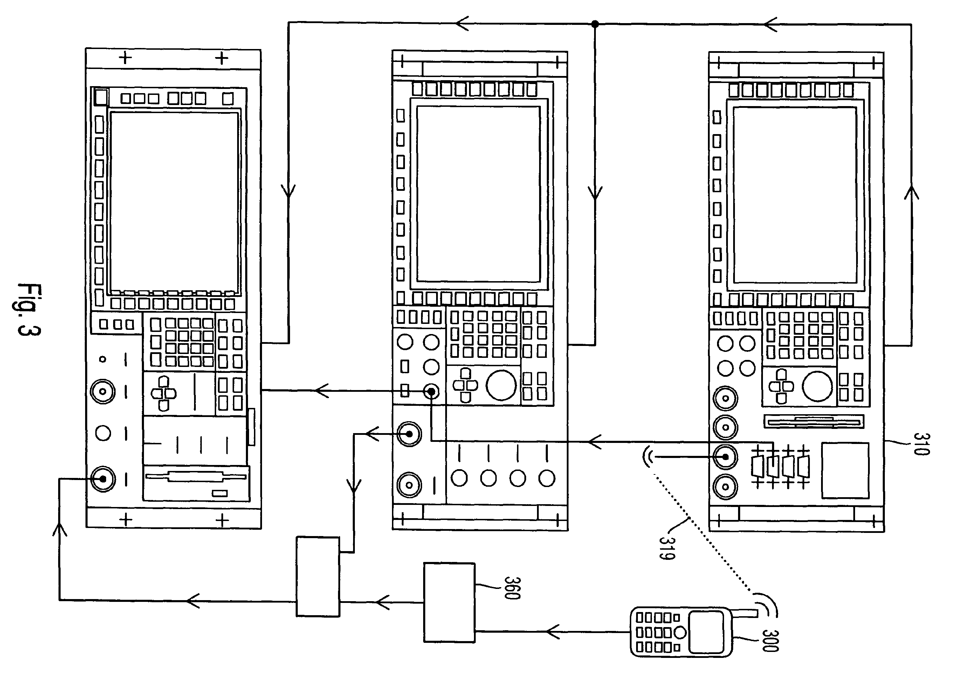

Zunächst wird der Aufbau und die Funktionsweise des erfindungsgemässen Messverfahrens und der erfindungsgemässen Messvorrichtung anhand der Figuren 1 und 2 beschrieben, bevor anhand der Figuren 3 bis 8 die Signale an verschiedenen Messstellen der Vorrichtung erläutert werden. Identische Elemente wurden in ähnlichen Abbildungen nicht wiederholt dargestellt und beschrieben.

Fig. 1 zeigt ein Ausführungsbeispiel einer erfindungsgemässen Vorrichtung zur Messung von Störaussendungen eines aktiv sendenden Messobjekts in einem Verschaltungsplan. Das Messobjekt 100 ist über die Verbindungsleitung 109 mit dem ersten Signalkombinierer 140 verbunden. Die Signalquelle 110 ist durch ihren Signalausgang 113 über die Verbindungsleitung 119 mit dem ersten Signalkombinierer 140 verbunden. Die Signalquelle 110 ist ferner durch ihren Referenzausgang 111 über die Verbindungsleitung 117 mit dem Referenzeingang 121 des Signalgenerators 120 und dem Referenzeingang 131 des Signalanalysators 130 verbunden. Der Triggerausgang 112 der Signalquelle 110 ist über die Verbindungsleitung 118 mit dem Triggereingang 122 des Signalgenerators 120 und dem Triggereingang 132 des Signalanalysators 130 verbunden. Der Signalausgang 123 des Signalgenerators 120 ist über die Verbindungsleitung 129 mit dem zweiten Signalkombinierer 150 verbunden. Der erste Signalkombinierer 140 ist über die Verbindungsleitung 149 mit dem zweiten Signalkombinierer 150 verbunden. Der zweite Signalkombinierer 150 ist über die Verbindungsleitung 159 mit dem Signaleingang 133 des Signalanalysators 130 verbunden.

Der erste Signalkombinierer 140 ist vorzugsweise ein resistiver Koppler mit einer Verzweigung, die aus mehreren Widerständen aufgebaut ist. Dadurch wird ein Signal aus der Leitung 119 nicht nur in die Leitung 149, sondern auch in die Leitung 109 eingekoppelt und somit an das Messobjekt 100 übertragen. Ein von dem Messobjekt 100 stammendes Signal wird über die Leitung 109 an den ersten Signalkombinierer 140 übertragen und somit in die Leitung 149 eingekoppelt.

Bei dem zweiten Signalkombinierer 150 kann es vorteilhaft sein, wenn dieser bezüglich den Leitung 149 und 159 eine geringe Einfügedämpfung hat. In diesem Fall ist der zweite Signalkombinierer 150 bevorzugt als Richtkoppler ausgebildet und das Signal der Leitung 129 wird in Richtung auf die Leitung 159 eingekoppelt. Da der Signalgenerator 120 kein Signal für das Messobjekt 100 zur Verfügung stellen muss, ist eine bidirektionale Kopplung beim zweiten Signalkombinierer 150 nicht erforderlich.

Bei der Signalquelle 120 kann es sich beispielsweise um das Mobilfunktestgerät CMU200 der Anmelderin handeln. Als Signalgenerator 120 ist beispielsweise der universelle Signalgenerator SMU200A der Anmelderin geeignet. Als Signalanalysator 130 eignet sich beispielsweise der Spektrumanalysator FSU der Anmelderin. Diese Geräte sind sowohl zur Erzeugung als auch Analyse von GSM-Signalen, GPRS-Signalen als auch von WCDMA-Signalen oder von Signalen zukünftiger Mobilfunk-Generationen geeignet.

Fig. 2 zeigt den, zu dem in Fig. 1 gezeigten Ausführungsbeispiel gehörenden Signalflussplan.
Die Signalquelle 110, der Signalgenerator 120 und der Signalanalysator 130 werden durch die Verbindungsleitung 117 mit einem gemeinsamen Referenzsignal Ref, z.B. ein 10MHz Sinussignal, versorgt. Das von der Signalquelle 110 erzeugte Triggersignal Trig wird über die Verbindungsleitung 118 an den Signalgenerator 120 und den Signalanalysator 130 übermittelt. Das Messobjekt 100 wird in einen Betriebszustand versetzt, in welchem es eingehende Daten als moduliertes Hochfrequenz-Signal aussendet. Die Signalquelle 110 sendet über die Verbindungsleitung 119, den Signalkombinierer 140 und Verbindungsleitung 109 eine bekannte Datenfolge Data an das Messobjekt 100. Das Messobjekt 100 sendet den Datenstrom moduliert auf einem Hochfrequenz-Signal HF1 über die Verbindungsleitung 109 an den ersten Signalkombinierer 140 und weiter über die Verbindungsleitung 149 an den zweiten Signalkombinierer 150.

Der Signalgenerator 120 erzeugt durch den Triggerimpuls Trig, den die Signalquelle 110 initiiert, ein ideales Hochfrequenz-Signal HF2 aus dem hier ebenfalls bekannten Datenstrom Data. Dabei wird das Signal so generiert, dass an dem ersten Signalkombinierer 150 kohärent invertierte, aber ansonsten identische Signale ankommen. Kohärent invertiert bedeutet im Rahmen dieser Anmeldung, dass die Signale gleiche Frequenz und Amplitude aber eine um ca. 180° versetzte Phasenlage zueinander haben. Das Signal wird über die Verbindungsleitung 129 an den zweiten Signalkombinierer 150 übertragen. Hier kommen die Signale zur Überlagerung. Destruktive Interferenz findet statt. Die nicht ausgelöschten Signalanteile HF3, die Störaussendungen des Messobjekts 100, werden über die Verbindungsleitung 159 an den Signaleingang 133 des Signalanalysators 130 übertragen. Auch hier wird die Messung anhand des Trigger-Signals Trig der Signalquelle 110 gestartet. Ohne weitere Filterung kann hier das Signal HF3, welches lediglich die Störaussendungen enthält, gemessen werden. Ein sehr gutes Signal-Rausch-Verhältnis kann so erreicht werden.

Fig. 3 zeigt ein weiteres Ausführungsbeispiel einer erfindungsgemässen Vorrichtung zur Messung von Störaussendungen eines aktiv sendenden Messobjekts in einem Blockschaltbild. Die Datenquelle ist hier durch einen Verbindungsteilnehmer 310 ausgebildet, der eine Basisstation emuliert. Der Datenstrom wird über die Luftschnittstelle 319 an das Messobjekt, hier ein Mobiles Kommunikationsgerät 300, übertragen.

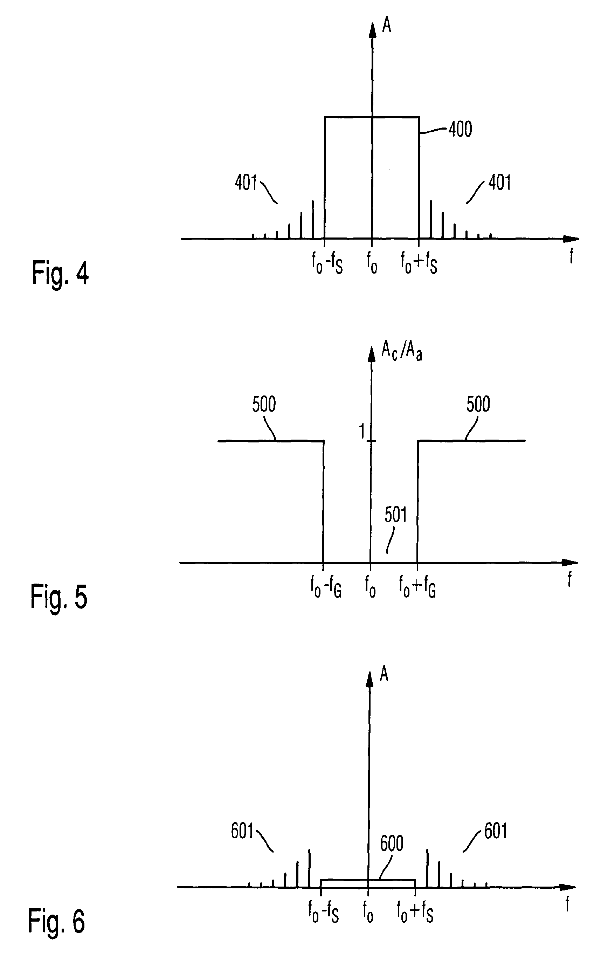

Fig. 4 zeigt ein beispielhaftes Ausgangs-Signal eines Messobjekts 100 am Hochfrequenz-Ausgang. Die Darstellung erfolgt im Frequenzbereich. Deutlich sichtbar ist die Bandbegrenzung des modulierten Trägersignals 400. Neben dem gewollten modulierten Trägersignal 400 treten Störaussendungen 401 in Nachbarkanälen auf. Sie sind gewöhnlich von deutlich geringerer Amplitude als das Trägersignal.

Fig. 5 zeigt die Kennlinie eines Bandsperrfilters im Frequenzbereich. Im Sperrbereich 501 dämpft es das Eingangs-Signal stark. Im Durchlassbereich 500 hat es nur geringen Einfluss auf das Eingangs-Signal. Um eine wie hier gezeigte Steilheit der Flanken des Filters zu erhalten, ist ein aufwendiger, teurer und großvolumiger Aufbau für jedes einzelne Bandsperrfilter notwendig. Um große Messflexibilität zu erreichen, ist es notwendig, verschiedene Trägerfrequenzen unterdrücken zu können. So ist eine Vielzahl dieser Bandsperrfilter notwendig, wobei zumindest ein Bandsperrfilter pro Frequenzbereich des Mobilfunksystems und im Extremfall ein Bandsperrfilter für jeden Mobilfunkkanal vorzusehen ist.

Fig. 6 zeigt ein beispielhaftes Signal HF3 als Kombination des vom Messobjekt 100 ausgesendeten Signals HF1 und des vom Signalgenerator 120 erzeugten Signals HF2 am Signalkombinierers 150. Die Darstellung erfolgt im Frequenzbereich. Deutlich sichtbar ist die Dämpfung des modulierten Trägersignals 600 im zu untersuchenden Kanal gegenüber dem nicht gedämpften modulierten Trägersignals 400 in Fig. 4. Neben dem gedämpften modulierten Trägersignal 600 treten Störaussendungen 601 außerhalb der Nutzbandbreite des zu untersuchenden Kanals auf. Diese sind nach der Dämpfung des modulierten Trägersignals 600 von vergleichbarer oder größerer Amplitude als das verbleibende modulierte Trägersignal. Erst durch die genannte Amplitudenanpassung können die Störaussendungen von einem weiteren Messgerät, z.B. dem Analysator 130, erfasst werden. Ohne die Amplitudenanpassung wäre bei für das Messgerät eine Messung mit gegebener Dynamik nicht möglich.

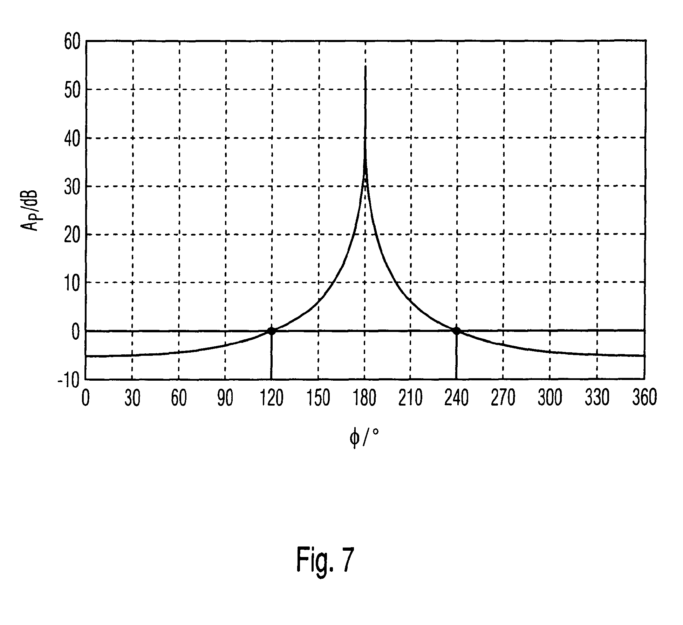

Fig. 7 zeigt die Phasenabhängigkeit der Dämpfung bei der aktiven Trägerunterdrückung. Das Dämpfungsmaß Ap des modulierten Trägers ist über der Phasenverschiebung ansonsten identischer Signale, welche zur Überlagerung gebracht werden, aufgetragen. Deutlich sichtbar ist, dass lediglich innerhalb eines Bereichs von 120° bis 240° Phasenverschiebung eine Dämpfung auftritt. Diese hat bei 180° ihr Maximum. Ist die Phasenverschiebung nicht innerhalb dieses Bereichs tritt keine Dämpfung, sondern eine Verstärkung auf. Es wird deutlich, dass eine exakte Phasenregelung von großer Bedeutung für den Erfolg einer aktiven Trägerunterdrückung ist. Vorteilhaft ist die Phasenverschiebung daher in Schritten von mindestens 0,2°, besser in Schritten von 0,1° einstellbar.

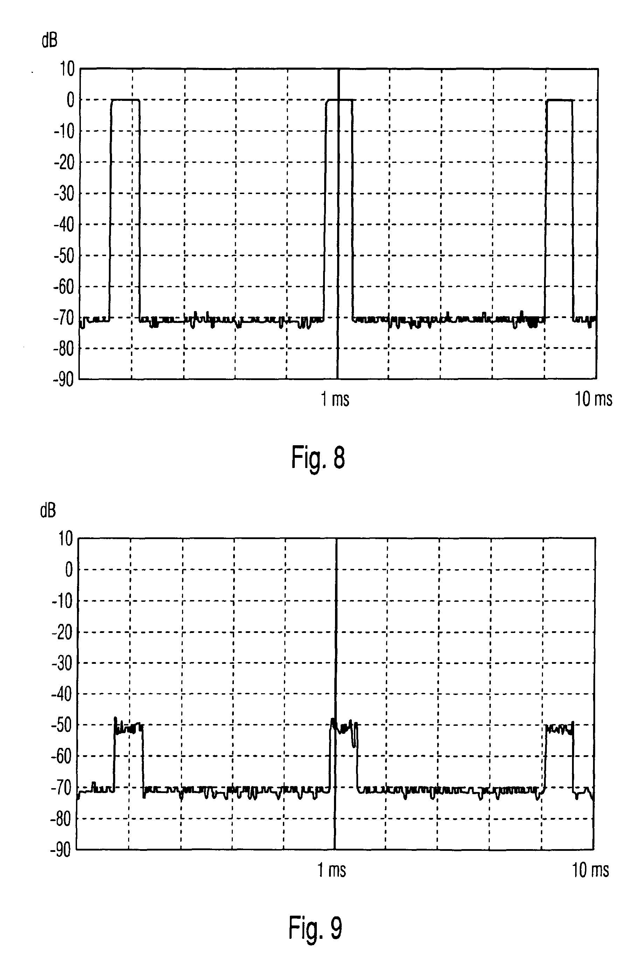

Fig. 8 zeigt ein gemessenes Hochfrequenz-Signal als Ausgangssignal eines idealen Messobjekts, d.h. ohne wesentliche Störaussendungen dargestellt im Zeitbereich. Deutlich sichtbar ist die geringe Signalstärke ausserhalb der Bandbreite des modulierten Trägersignals.

Fig. 9 zeigt ein gemessenes Hochfrequenz-Signal nach destruktiver Überlagerung der Signale dargestellt im Zeitbereich. Auch in dieser Darstellung wurde ein ideales Messobjekt verwendet. Die Dämpfung des modulierten Trägersignals auf ca. -50 dB ist deutlich sichtbar. Störaussendungen, die -50 dB oder noch schwächer gegenüber dem Nutzsignal ausgesandt werden, können jetzt gemessen werden und analysiert werden.

Die Erfindung ist nicht auf die dargestellten Ausführungsbeispiele beschränkt. Insbesondere können als Signalquelle 110, Signalgenerator 120 und Signalanalysator 130 auch andere Geräte als die vorstehend beschriebenen Geräte zum Einsatz kommen. Das erfindungsgemäße Verfahren eignet sich für unterschiedlichste Hochfrequenz-Messobjekte, beispielsweise auch Basisstationen, Funkgeräte und Signal-Generatoren, etc.. Sämtliche vorstehend beschriebenen und/oder gezeichneten Merkmale sind im Rahmen der Erfindung beliebig miteinander kombinierbar.

## Patentansprüche

1. Verfahren zum Messen von Störaussendungen eines aktiv sendenden Messobjekts (100) mit folgenden Verfahrensschritten:
mittelbares oder unmittelbares Zuführen eines bekannten, Datenstroms (Data), durch eine Signalquelle (110) an einen Eingang des Messobjekts (100),
und Versetzen des Messobjekts (100) in einen Betriebszustand, in welchem es jeglichen eingehenden Datenstrom als entsprechenden ausgehenden Datenstrom in modulierter Form aussendet,
mittelbares oder unmittelbares Zuführen eines ersten Hochfrequenz-Signals (HF1) von dem Messobjekt (100) über einen Signalkombinierer (150) zu einem Signalanalysator (130),
und mittelbares oder unmittelbares Zuführen eines zweiten Hochfrequenz-Signals (HF2), das von einem mit dem Messobjekt (100) synchronisierten Signalgenerator (120) erzeugt wird, über den Signalkombinierer (150) zu dem Signalanalysator (130).

2. Verfahren nach Anspruch 1,
**dadurch gekennzeichnet,**
**dass** das zweite Hochfrequenz-Signal (HF2) so erzeugt wird, dass es invertiert kohärent zu dem ersten Hochfrequenz-Signal (HF1) des Messobjekts (100) ist.

3. Verfahren nach Anspruch 1 oder 2,
**dadurch gekennzeichnet,**
**dass** der Signalgenerator (120) das Hochfrequenz-Signal (HF2) mit einem Zeitversatz ausgibt, welcher das zweite Hochfrequenz-Signal (HF2) zu dem von dem Messobjekt ausgegebenen ersten Hochfrequenzsignal (HF1) synchronisiert, und
**dass** die Phase des von dem Signalgenerator (120) ausgegebenen Hochfrequenz-Signals (HF2) der um 180° verschobenen Phase des durch das Messobjekt ausgegebenen Hochfrequenz-Signals (HF1) entspricht.

4. Verfahren nach einem der Ansprüche 1 bis 3,
**dadurch gekennzeichnet,**
**dass** das Hochfrequenz-Signal (HF2) des Signalgenerators (120) mit einem Modulations-Signal moduliert wird, welches dem dem Hochfrequenz-Signal (HF1) des Messobjekts (100) beaufschlagten Modulationssignal entspricht, und
**dass** an dem Signalgenerator (120) eine Phasenlage, mit welcher das Hochfrequenz-Signal (HF2) mit dem Modulations-Signal von dem Signalgenerator (120) moduliert wird, so eingestellt wird, dass die Phase des Modulations-Signals des Messobjekts (100) in Bezug auf das Modulations-Signal des Signalgenerators (120) um 180° verschoben ist.

5. Verfahren nach einem der Ansprüche 1 bis 4,
**dadurch gekennzeichnet,**
**dass** das Messobjekt (100) ein mobiles Kommunikationsgerät (300), insbesondere ein zelluläres Mobilfunkgerät, mit einem Hochfrequenz-Verstärker ist, wobei zwischen dem Messobjekt (100) und dem Signalkombinierer (150) ein Dämpfungsglied (360) angeordnet wird und der Dämpfungsfaktor des Dämpfungsglieds (360) so bemessen wird, dass der Signalpegel am Ausgang des Dämpfungsglieds (360) in etwa mit dem Signalpegel am Ausgang des Signalgenerators (120) übereinstimmt, und
**dass** der am Messobjekt eingehende Datenstrom (Data) von einem Verbindungsteilnehmer (310) erzeugt wird,
wobei die Übertragung über eine Luftschnittstelle (319) erfolgt.

6. Verfahren nach einem der Ansprüche 1 bis 4,
**dadurch gekennzeichnet,**
**dass** an dem Signalgenerator (120) eine Amplitude, mit welcher das Hochfrequenz-Signal (HF2) von dem Signalgenerator (120) ausgegeben wird, so eingestellt wird, dass die Amplituden, mit welchen die Hochfrequenz-Signale (HF1, HF2) des Signalgenerators (120) und des Messobjekts (100) an dem Signalkombinierer (150) ankommen, in etwa gleich sind.

7. Messvorrichtung zum Messen von Störaussendungen eines aktiv sendenden Messobjekts (100)
mit einer Signalquelle (110), welche dem Eingang des Messobjekts (100) einen bekannten Datenstrom (Data) zuführt, wobei das Messobjekt (100) in einem Betriebszustand versetzt ist, in welchem es jeglichen eingehenden Datenstrom als entsprechenden ausgehenden Datenstrom in modulierter Form über einen Hochfrequenzausgang als erstes Hochfrequenz-Signal (HF1) aussendet,
mit einem Signalkombinierer (150), dessen erster Eingang mit dem Ausgang des Messobjekts (100) mittelbar oder unmittelbar in Verbindung steht,
mit einem Signalanalysator (130), der mit dem Ausgang des Signalkombinierers (150) mittelbar oder unmittelbar in Verbindung steht,
und mit einem mit dem Messobjekt (100) synchronisierten Signalgenerator (120), der ein zweites Hochfrequenz-Signal (HF2) erzeugt, das einem zweiten Eingang des Signalkombinierers (150) mittelbar oder unmittelbar zugeführt ist.

8. Messvorrichtung nach Anspruch 7,
**dadurch gekennzeichnet,**
**dass** der Signalgenerator (120) das zweite Hochfrequenz-Signal (HF2) invertiert kohärent zu dem ersten Hochfrequenz-Signal (HF1) des Messobjekts (100) erzeugt.

9. Messvorrichtung nach Anspruch 7 oder 8,
**dadurch gekennzeichnet,**
**dass** in dem Signalgenerator (120) eine Zeitverzögerung, mit welcher das zweite Hochfrequenz-Signal (HF2) ausgegeben wird, einstellbar ist, wobei die Zeitverzögerung so eingestellt ist, dass das erste Hochfrequenz-Signal (HF1) von dem Messobjekt (100) in Bezug auf das von dem Signalgenerator (120) ausgegebene zweite Hochfrequenz-Signal (HF2) synchronisiert ist, und dass die Phase des von dem Signalgenerator (120) ausgegebenen zweiten Hochfrequenz-Signals (HF2) einstellbar ist, wobei die Phase so eingestellt ist, dass das zweite Hochfrequenzsignal (HF2) des Signalgenerators (120) einer um 180° verschobenen Phase des durch das Messobjekt (100) ausgegebenen Hochfrequenz-Signals (HF1) entspricht.

10. Messvorrichtung nach Anspruch 9,
**dadurch gekennzeichnet,**
**dass** die Schrittweite, mit welcher die Phasenlage des Hochfrequenz-Signals (HF2) des Signalgenerators (120) einstellbar ist, weniger als 0,2°, bevorzugt weniger als 0,1° ist.

11. Messvorrichtung nach einem der Ansprüche 7 bis 10,
**dadurch gekennzeichnet,**
**dass** das zweite Hochfrequenz-Signal (HF2) des Signalgenerators (120) mit einem Modulations-Signal moduliert ist, und in dem Signalgenerator (120) eine Phasenlage, mit welcher das zweite Hochfrequenz-Signal (HF2) mit dem Modulations-Signal von dem Signalgenerator (120) moduliert ist, einstellbar ist, wobei die Phasenlage so eingestellt ist, dass das Modulations-Signal des Signalgenerators (120) in Bezug auf das Modulations-Signal des Messobjekts (100) um 180° verschoben ist.

12. Messvorrichtung nach Anspruch 11,
**dadurch gekennzeichnet,**
**dass** die Schrittweite, mit welcher die Phasenlage des Modulations-Signals des Signalgenerators (120) einstellbar ist, weniger als 0,2°, bevorzugt weniger als 0,1° ist.

13. Messvorrichtung nach einem der Ansprüche 7 bis 12,
**dadurch gekennzeichnet,**
**dass** das Messobjekt (100) ein mobiles Kommunikationsgerät (300), insbesondere ein zelluläres Mobilfunkgerät, mit einem Hochfrequenz-Verstärker ist,
**dass** zwischen dem Messobjekt (100) und dem Signalkombinierer (150) ein Dämpfungsglied (360) angeordnet ist und der Dämpfungsfaktor des Dämpfungsglieds (360) so bemessen ist, dass der Signalpegel am Ausgang des Dämpfungsglieds (360) in etwa mit dem Signalpegel am Ausgang des Signalgenerators (120) übereinstimmt,
**dass** die Signalquelle (110), die den Datenstrom zum Eingang des Messobjekts (100) erzeugt, ein Verbindungsteilnehmer (310) ist, und
**dass** die Übertragung des Datenstroms (Data) von der Signalquelle (110) zum Messobjekt (100) über eine Luftschnittstelle (319) erfolgt.

14. Messvorrichtung nach einem der Ansprüche 7 bis 12,
**dadurch gekennzeichnet,**
**dass** in dem Signalgenerator (120) eine Amplitude, mit welcher das zweite Hochfrequenz-Signal (HF2) von dem Signalgenerator (120) ausgegeben wird, einstellbar ist,
wobei die Amplitude so eingestellt ist, dass die Amplituden, mit welchen die Hochfrequenz-Signale (HF1, HF2) des Signalgenerators (120) und des Messobjekts (100) an dem Signalkombinierer (150) ankommen, in etwa gleich sind.

15. Messvorrichtung nach einem der Ansprüche 7 bis 14,
**dadurch gekennzeichnet,**
**dass** der Datenstrom (Data), den die Signalquelle (110) an das Messobjekt (100) überträgt, im Signalgenerator (120) vorliegt.
